# EUROPÄISCHE PATENTSCHRIFT

(11) **EP 2 010 351 B1**
(45) Veröffentlichungstag und Bekanntmachung des Hinweises auf die Patenterteilung: **27.06.2012**
(21) Anmeldenummer: 07724433.3
(22) Anmeldetag: 20.04.2007
(51) Int. Cl.: B23H 3/00, C25D 3/00

(54) **VERFAHREN ZUR OBERFLÄCHENBEHANDLUNG EINER ELEKTRISCH LEITENDEN, METALLISCHEN SUBSTRATOBERFLÄCHE**
METHOD FOR TREATING THE SURFACES OF AN ELECTRICALLY CONDUCTIVE METALLIC SUBSTRATE SURFACE
PROCÉDÉ DE TRAITEMENT DE SURFACE D'UN SUBSTRAT MÉTALLIQUE CONDUCTEUR D'ÉLECTRICITÉ.

(30) Priorität: 21.04.2006 DE 102006019189; 30.06.2006 DE 102006030323
(43) Veröffentlichungstag der Anmeldung: 07.01.2009
(60) Teilanmeldung: 08022415.7
(73) Patentinhaber: Fraunhofer-Gesellschaft zur Förderung der angewandten Forschung e.V., 80686 München (DE)
(72) Erfinder: QUENZER, Hans-Joachim, 25524 Itzehoe (DE); ZWICKER, Gerfried, 25525 Itzehoe (DE)
(74) Vertreter: Rösler, Uwe
(86) Internationale Anmeldenummer: PCT/EP2007/003497
(87) Internationale Veröffentlichungsnummer: WO 2007/121948

(56) Entgegenhaltungen:
- WO-A-2005/008783
- JP-A- 58 025 488
- US-A- 5 795 653
- US-A1- 2002 197 761

## Beschreibung

### Technisches Gebiet

Die Erfindung bezieht sich auf ein Verfahren zur Oberflächenbehandlung einer elektrisch leitfähigen, metallischen Substratoberfläche, mit dem es möglich ist Mikro-und Nanostrukturen in die Oberfläche des Substrates einzubringen. Typische Anwendungsbereiche eines derartigen Verfahrens stellen die Einebnung technischer Oberflächen zur Herstellung hochplaner Flächen, bspw. in Form von Spiegeloberflächen, oder die Herstellung mechanisch, elektronisch und/oder optisch wirksamer Strukturen dar.

### Stand der Technik

Gattungsgemäße Verfahren zur Oberflächenbehandlung von Substratoberflächen, insbesondere von metallischen Substratoberflächen, stellen entweder an sich bekannte Materialabtrageverfahren, wie beispielsweise nasschemische Ätztechniken, oder Materialabscheideverfahren dar, wie beispielsweise galvanische Verfahren, Sputter- oder Aufdampfverfahren, um nur einige zu nennen. In allen bekannten Verfahren gilt es an einer zu bearbeitenden Substratoberfläche für den jeweiligen Prozess erforderliche Prozessbedingungen zu schaffen, die zum Teil mit großem apparativen Aufwand und damit auch mit hohen Kostenaufwendungen verbunden sind. Beispielsweise gilt es zur Abscheidung von Materialschichten auf einer Substratoberfläche eine entsprechende Vakuumkammer bereitzuhalten, in der unter Vakuumbedingungen bestimmte Materialabscheidungen an der Substratoberfläche vorgenommen werden können. Der Einsatz nasschemischer Abscheideverfahren sowie auch Ätzverfahren setzt die Bereitstellung chemischer Bäder mit darin vorherrschenden elektrostatischen Bedingungen voraus, die neben dem hohen verfahrenstechnischem Aufwand auch zusätzliche Sicherheits- sowie auch Entsorgungsprobleme entstehen lassen.

Auch sind Planarisierungstechniken zur Einebnung von Substratoberflächen bekannt, die auf Basis chemisch mechanischen Polierens erfolgen, insbesondere von Cu-Oberflächen in der Mikroelektronik. Daneben können auch mit Hilfe des so genannten "Reverse Plating" durch Umkehrung eines galvanischen Abscheideprozesses überstehende Materialbereiche abgetragen werden. Auch diese Technik kann zur Einebnung von Materialabscheidungen eingesetzt werden.

Aus der US 2006/0164880 A1 ist ein Schaltelement in Art eines Transistors zu entnehmen, dessen Schaltfunktion in Abhängigkeit einer an die Gate-Elektrode angelegten elektrischen Spannung auf Basis eines Austausches von Metallionen zwischen der Source- und Drain-Elektrode erfolgt.

### Darstellung der Erfindung

Der Erfindung liegt die Aufgabe zugrunde eine Oberflächenbehandlung an metallischen Substratoberflächen zu ermöglichen, ohne dabei einen großen apparativen sowie auch kostenrelevanten Aufwand tragen zu müssen, wobei es gilt die Oberflächenbeschaffenheit gezielt zu beeinflussen, d.h. diese zu strukturieren im Sinne einer lokalen Materialabscheidung oder auch einer lokalen Materialabtragung. Das lösungsgemäße Verfahren soll insbesondere zur Planarisierung von Substratoberflächen einsetzbar sein, wie beispielsweise zur Einebnung metallisierte Wafer.

Die der Erfindung zugrunde liegende Aufgabe wird durch ein im Anspruch 1 angegebenes Verfahren gelöst. Den Erfindungsgedanken vorteilhaft weiterbildende Merkmale sind Gegenstand der Unteransprüche sowie der weiteren Beschreibung insbesondere unter Bezugnahme auf die Ausführungsbeispiele zu entnehmen.

Das lösungsgemäße Verfahren zur Oberflächenbehandlung einer metallischen Substratoberfläche bedient sich eines festen Ionen leitenden Materials aufweisenden Werkzeuges, das wenigstens bereichsweise auf die metallische Substratoberfläche kraftbeaufschlagt gepresst wird. Das Ionen leitende Material des Werkzeuges ist dabei derart ausgewählt, dass es Metallionen der Substratoberfläche zu leiten vermag, vorzugsweise ohne dabei selbst Materialan- oder Ablagerungen oder sonstige Degradationen zu erfahren. Zudem wird zwischen der Substratoberfläche und dem Werkzeug ein elektrisches Potenzial angelegt, so dass die Metallionen in Bereichen, in denen das Werkzeug mit der Substratoberfläche kraftbeaufschlagt in Kontakt tritt, durch das Werkzeug von der Substratoberfläche abgezogen oder auf die Substratoberfläche abgeschieden werden.

Das lösungsgemäße Verfahren eröffnet somit in Abhängigkeit von dem zwischen der Substratoberfläche und dem Werkzeug angelegten elektrischen Potenzial sowie in Abhängigkeit der Materialwahl hinsichtlich des Substrats bzw. der Substratoberfläche und dem jeweiligen Werkzeug sowie in Abhängigkeit von der Formbeschaffenheit des Werkzeuges, die letztlich Form und Größe der Kontaktbereiche zwischen Werkzeug und Substratoberfläche bestimmt, die Möglichkeit lokale oder ganzflächige Materialabscheidungen oder Materialabtragungen an der Substratoberfläche vorzunehmen und dies ohne die Notwendigkeit der Schaffung verfahrenstechnisch komplizierter Prozessbedingungen sowie die hierfür erforderlichen apparativen Voraussetzungen. Vielmehr beruht die lösungsgemäße Oberflächenbehandlung auf rein elektrochemische Vorgänge. Zur Effizienzsteigerung des lösungsgemäßen Verfahrens ist es allenfalls vorteilhaft, den Vorgang der Materialabscheidung bzw. Materialaufbringung unter einem gegenüber Raumtemperatur erhöhten Temperaturniveau, beispielsweise bei Temperaturen von ca. 80° C, durchzuführen, zumal sich bei zunehmenden Temperaturen die Ionenleitfähigkeit erhöht.

Das Werkzeug, mit dem die lösungsgemäße Oberflächenbehandlung der metallischen Substratoberfläche durchgeführt wird, besteht vorzugsweise aus einem festen ionenleitenden Material, das über eine der Substratoberfläche zugewandte Werkzeugoberfläche verfügt, die je nach Oberflächenbehandlungsziel geeignet strukturiert oder unstrukturiert, d.h. plan oder glatt, ausgebildet ist. Die Werkzeugoberfläche wird zur Oberflächenbehandlung fest auf die Substratoberfläche unter Ausbildung eines innigen, kraftbeaufschlagten Flächenkontaktes angepresst. Zumindest die zu behandelnde Substratoberfläche besteht aus einem Metall bzw. weist Anteile eines Metalls auf, das die Metallionen in das die Ionen leitende Werkzeug abgeben bzw. von diesem aufnehmen kann. Zwischen der Substratoberfläche und der Rückseite des aus Ionen leitendem Material bestehenden Werkzeuges wird im Weiteren eine geeignet gewählte elektrische Spannung angelegt, die im Falle eines kationischen Ionenleiters im Kontaktbereich zwischen Werkzeug und Substratoberfläche zur Emission von Metallionen aus der metallischen Substratoberfläche in das aus ionenleitendem Material bestehende Werkzeug führt, vergleichbar mit einem galvanischen Element mit flüssigen Elektrolyten.

Durch die Emission der Ionen an der Substratoberfläche kommt es analog zu Vorgängen in galvanischen Anlagen mit löslicher Anode zu einem kontinuierlichen Materialabtrag, wobei die Substratoberfläche lokal, d.h. ausschließlich an den Kontaktbereichen zum Werkzeug, geätzt wird.

Da das aus ionenleitendem Material bestehende Werkzeug kraftbeaufschlagt gegen die Substratoberfläche gepresst wird, sinkt das Werkzeug kontinuierlich in die Substratoberfläche solange ein, solange der Ätzvorgang andauert, d.h. solange das Werkzeug kraftbeaufschlagt gegen die Substratoberfläche gepresst wird, während ein elektrisches Potenzial zwischen Substratoberfläche und Werkzeug anliegt. Wie bereits erwähnt kommt es im Unterschied zur Verwendung flüssiger Elektrolyte nur zu einem lokalen Ätzvorgang bzw. Materialabtrag im Kontaktbereich, d.h. in jenen Bereichen, in denen das Werkzeug im Flächenkontakt mit der Substratoberfläche steht. Besonders vorteilhaft ist es, wenn das aus Ionen leitende Material bestehende Werkzeug das zu ätzende Metall vollständig und rückstandsfrei zu transportieren vermag, so dass das Werkzeug keine Änderung hinsichtlich der chemischen Zusammensetzung erfährt.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnungen exemplarisch beschrieben. Es zeigen:
- Fig. 1a, b: Ausführungsbeispiele zur Durchführung des lösungsgemäßen Verfahrens zum lokalen Materialabtrag an einer Substratoberfläche,
- Fig. 2a, b: Ausführungsbeispiel zur Darstellung der Planarisierung eines Flächensubstrates mittels des lösungsgemäßen Verfahrens,
- Fig. 3: Ausführungsbeispiel zum lokalen Materialabtrag mittels eines anionischen Ionenleiters für Fluorid Ionen sowie
- Fig. 4 .: Ausführungsbeispiel zum lokalen Materialabtrag mittels eines anionischen Ionenleiters aus ZrO₂.

### Wege zur Ausführung der Erfindung, gewerbliche Verwendbarkeit

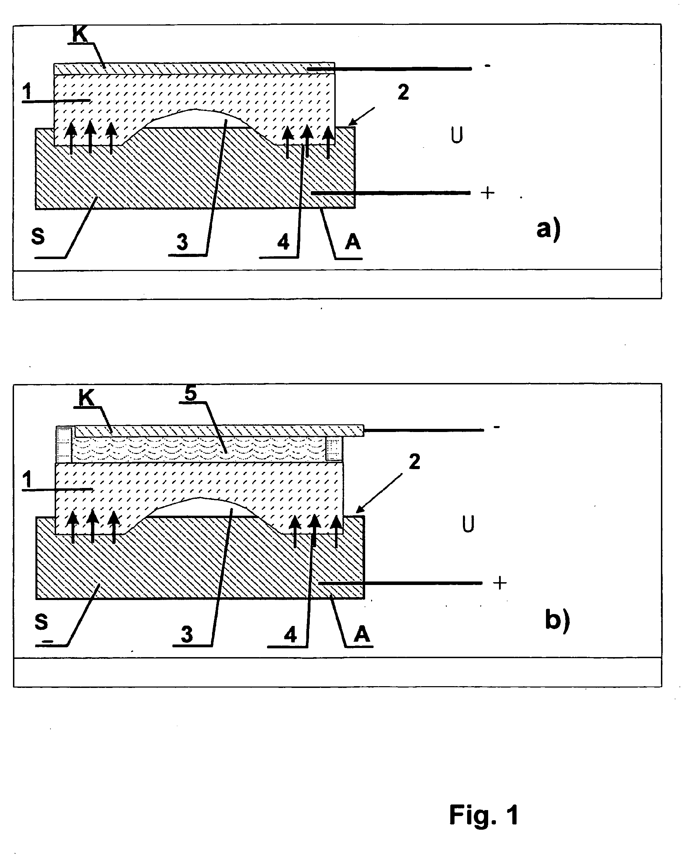

In Figur 1 ist ein schematischer Aufbau zur Durchführung des lösungsgemäßen Verfahrens zum oberflächigen Materialabtrag an einem aus Kupfer bestehenden Substrat dargestellt. Hierzu liegt das Werkzeug 1, das selbst aus einem Kupferionen leitenden Material, vorzugsweise aus Kupfer-Rubidium-Chlorid besteht auf der Substratoberfläche 2 des Substrats S auf. Die der Substratoberfläche 2 zugewandte Seite des Werkzeuges 1 ist unter Massgabe einer bestimmten, in die Substratoberfläche 2 einzubringenden Oberflächenkontur strukturiert. Im Falle des Ausführungsbeispiels gemäß Figur 1a, b sieht das Werkzeug 1 hierzu eine konkave Ausnehmung 3 vor, die von einem planen Umfangsrand 4 umgeben ist. Zu Beginn des Materialabtragsverfahrens sitzt der Umfangsrand 4 auf der Substratoberfläche 2 flächig auf. Zwischen dem Werkzeug 1 und dem Substrat S wird eine elektrische Potenzialdifferenz in der in Figur 1a angegebenen Weise angelegt, d.h. die Rückseite des Werkzeuges 1 wird zur Kathode K und das Substrat S zur Anode A. Wie bereits vorstehend erwähnt, eignet sich besonders bevorzugt Kupfer-Rubidium-Gilt es im Gegensatz zu einem Ätzvorgang auf der Substratoberfläche kontrolliert Metall abzuscheiden, so läßt sich durch Umkehrung der Polarität der anliegenden elektrischen Spannung Metall im Kontaktbereich aus dem, aus Ionen leitenden Material bestehendem Werkzeug an der Substratoberfläche abscheiden. Durch den gewählten Betrag des elektrischen Potenzials ist es zudem möglich, die Menge des abzuscheidenden Metalls sowie die Geschwindigkeit der Metallabscheidung auf die Substratoberfläche vorzugeben. Vergleichbar dem sogenannten Pulsplating sind somit Ätzvorgänge, d.h. Materialabtragsvorgänge vorstellbar, bei denen durch die Verwendung periodischer Pulswellen anstelle einer elektrischen Gleichspannung, die zwischen der Substratoberfläche und dem Werkzeug angelegt wird, neben den Ätzprozessen auch zeitweilig Abscheidevorgänge stattfinden, allerdings nur mit dem Ziel, den Abtragsvorgang besser steuern zu können.

Als besonderen Vorteil des lösungsgemäßen Verfahrens ist zu nennen, dass die Materialabscheidung oder der Materialabtrag grundsätzlich ohne ein Auftreten von reaktionsbedingten chemischen Nebenprodukten realisierbar ist. Vielmehr basieren die Materialabscheide- bzw. Materialabtragsvorgänge auf dem Übergang von Metallionen zwischen dem Werkzeug und der Substratoberfläche und umgekehrt.

Werden hingegen als Ionen leitendes Material ein anionischer Ionenleiter als Werkzeugmaterial eingesetzt, so können an der Grenzfläche zwischen dem Werkzeug und der Substratoberfläche reaktive Gase, gegebenenfalls auch in atomarer Form auftreten, die unmittelbar zu einer chemischen Reaktion an der Grenzfläche zwischen dem aus Ionen leitenden Material bestehenden Werkzeug und der elektrisch leitenden Substratoberfläche führen. Treten derartige Reaktionsprodukte in gasförmiger Form, beispielsweise bei Verwendung von Fluorionenleitem auf, so kann dieser Prozess für lokale Ätzprozesse genutzt werden, wie in einem Ausführungsbeispiel weiter unten ausgeführt wird.

Chlorid als Material für das Werkzeug 1, zumal Kupfer-Rubidium-Chlorid bei Raumtemperatur ein sehr guter lonenleiter für Kupferionen ist. Überdies eignet sich das Material sehr gut als Werkstoff für die Herstellung beliebiger Werkstückoberflächen, zumal das Material relativ einfach aus beiden Salzen erhalten werden kann und bei Temperaturen von ca. 250°C schmelzbar ist, wohingegen unterhalb des Schmelzpunktes ein hartes, massives Materialgefüge vorliegt. Zur Herstellung eines geeigneten Werkzeuges kann das in flüssiger Schmelze vorliegende Material in eine geeignete Masterform eingegossen werden, aus der das Material in Form einer erkalteten Schmelze abgetrennt werden kann. Das auf diese Weise erhaltene Werkzeug dient anschließend zum lokalen Materialabtrag im Rahmen eines sogenannten elektrochemischen Senkvorganges, bei dem die der Substratoberfläche 2 zugewandte Werkzeugseite auf die gereinigte, glatte Kupfersubstratoberfläche aufgelegt und eine elektrische Spannung zwischen dem Ionen leitenden Werkzeug 1 und dem Substrat S angelegt wird. Nur an den sich berührenden Flächen können sich nun Kupferatome aus dem Metall des Substrats S lösen und in das Ionen leitende Werkzeug eindringen. Bedingt durch diesen Materialtransport senkt sich das Werkzeug 1 nach und nach immer mehr in die Substratoberfläche 2 ein, bis schließlich die gesamte Fläche des Werkzeuges 1 mit dem Substrat S in Kontakt kommt. Nach Beenden des Abtragsvorganges und Abheben des Werkzeuges 1 von der nun strukturierten Substratoberfläche, bleibt eine inverse Wiedergabe der Werkzeugkontur auf dem Substrat S zurück.

Das während des elektrochemischen Senkvorganges abgetragene Kupfer wird an der rückwärtigen Kathode K angelagert. Um etwaigen Problemen durch Aufwachsen von Kupfer an der Kathode K zu entgegnen, kann zweckmäßigerweise anstelle einer metallisch leitfähigen Kathode K gemäß dem Ausführungsbeispiel in Figur 1a ein Ionen leitender Elektrolyt 5 gemäß dem Ausführungsbeispiel in Figur 1b zwischen dem Ionen leitenden Werkzeug 1 und der Anode A vorgesehen werden. Der Ionen leitende Elektrolyt 5 kann in Form eines in Lösung, bspw. in Wasser, vorliegenden Kupfersalzes oder in einem sonstigen Lösungsmittel oder einer Salzschmelze, beispielsweise auch in Form eines organischen Salzes vorliegen, wobei der in flüssiger Form vorliegende Elektrolyt 5 entsprechend an der Rückseite des Werkzeuges 1 gekapselt ist, wobei die Kathode K eine Begrenzungsfläche der Elektrolytkapselung darstellt. Der Elektrolyt 5 dient als Puffer bzw. Reservoir für die Kupferionen, wobei Kupferionen je nach elektrischem Potenzial vom Elektrolyt aufgenommen oder von diesem abgegeben werden.

Besonders eignet sich das lösungsgemäße Verfahren zur Replikation von Laserspiegel, die vorzugsweise aus einkristalinem Kupfer herstellbar sind.

Gleichermaßen interessant erscheint jedoch auch die Nutzung des lösungsgemäßen Verfahrens zur Planarisierung sowie Politur von Substratoberflächen, wie beispielsweise Kupferoberflächen. Hierbei ist es erforderlich, dass das aus Kupfer-Rubidium-Chlorid bestehende Werkzeug über eine glatte und eben ausgebildete Werkzeugoberfläche verfügt, die auf die Substratoberfläche des Kupfersubstrates aufsetzbar ist. In einem derartigen Fall handelt es sich gewissermaßen um eine sogenannte trockene CMP, d.h. chemisch mechanisches Polieren, die sich besonders bevorzugt zur Herstellung von Kupfer-Metallisierungen auf Silizium-Wafern einsetzen lässt. An dieser Stelle sei betont, dass das lösungsgemäße Verfahren auch an Substratoberflächen bzw. Substraten anwendbar ist, die beispielsweise aus Silber oder Silber-Kupferlegierungen bestehen, die zur Metallionenleitung gleichermaßen in der Lage sind.

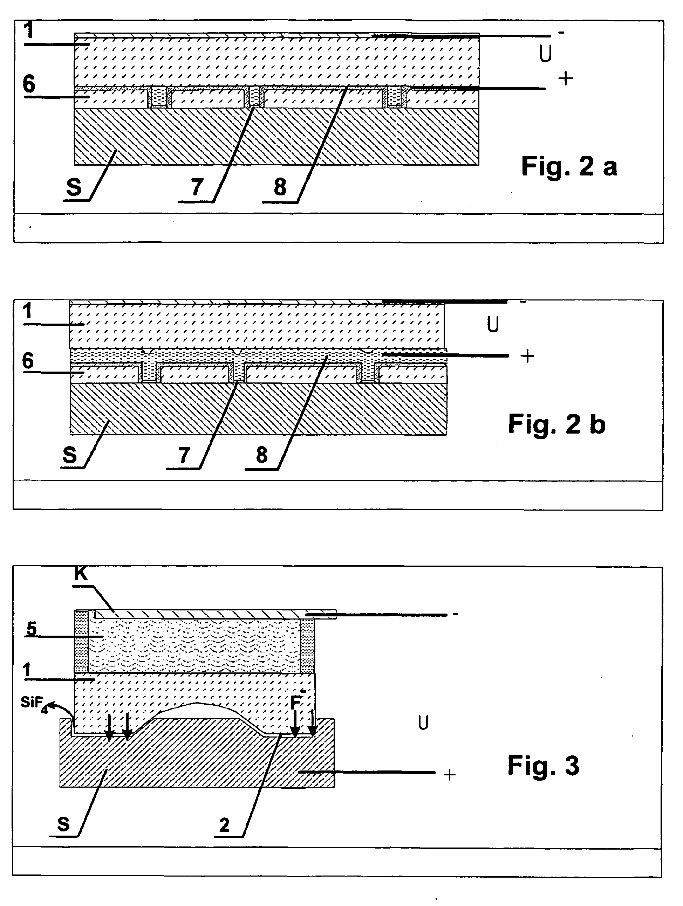

Zur Erläuterung einer Planarisierung einer Substratoberfläche unter Verwendung des lösungsgemäßen Verfahrens sei unter Bezugnahme auf die Figuren 2a und b ein sogenannter Damascene-Prozess beschrieben, bei dem es erforderlich ist, eine überstehende Kupferschicht über einen metallisierten Wafer zu entfernen. Hierzu wird auf den metallisierten Wafer - im dargestellten Fall besteht dieser aus einem Silizium-Substrat, einer darauf aufgebrachten dielektrischen Schicht 6, die strukturiert und von einer dünnen Tantal(Ta)-Schicht 7 überzogen ist, die ihrerseits vollständig von einer Kupferschicht 8 überragt wird, die es zu planarisieren gilt - ein Werkzeug 1 mit planer Werkzeugoberfläche aufgesetzt und angedrückt.

Dieser Fall ist in Figur 2a dargestellt. Zwischen der metallisierten Oberfläche des strukturierten Wafers, d.h. zwischen der Kupferschicht 8 und dem Ionen leitenden Werkzeug, wird eine elektrische Spannung angelegt, so dass die Kupferionen im Kontaktbereich zwischen der Kupferschicht 8 und dem Werkzeug 1 in das Ionen leitende Werkzeug eintreten und auf dessen Rückseite, d.h. Kathodenseitig abgeschieden werden. Damit fließt während des Materialabtragsvorganges, der einem Ätzvorgang vergleichbar ist, ein elektrischer Strom zwischen der Oberfläche des strukturierten Wafers und der Anode des ionenleitenden Werkzeuges 1.

Der Vorgang des elektrochemischen Abtragens des Kupfers dauert solange an, bis das Kupfer in den Kontaktbereichen vollständig abgetragen ist und die Ionen leitende Oberfläche des Werkzeuges mit der unter dem Kupfer liegenden Barriereschicht, in Form der Tantalschicht 7, in Kontakt gelangt. Damit kommt der Ätzvorgang bzw. der Materialabtragsvorgang zum Erliegen und das weitere Ätzen des Kupfers wird unterbrochen (Kupfer-Damascene-Technik). Dieser Vorgang wird auch anhand des Absinkens des elektrischen Stromflusses durch das Ionen leitende Werkzeug hindurch deutlich und ermöglicht damit eine Endpunkterkennung des Ätzprozesses.

Diese Situation ist in Figur 2b näher illustriert, bei der das Ionen leitende Werkzeug 1 plan auf der strukturierten, mit der Tantalschicht 7 überzogenen dielektrischen Schicht 6 aufliegt.

Bedingt durch die vergleichsweise hohe Ionenleitfähigkeit des Kupfer-Rubidium-Chlorids, aus dem das Werkzeug 1 besteht, kann der Vorgang durchaus auch bei Raumtemperatur durchgeführt werden, allerdings ist es vorteilhaft den Abtragsvorgang durch Erwärmen auf ca. 80°C aufgrund der bei diesen gegenüber Raumtemperatur erhöhten Temperaturen verbesserten Ionenleitfähigkeit durchzuführen.

Die vorhandene Tantalschicht 7 eignet gleichsam wie bspw. eine Tantalnitridschicht als Barriereschicht 8 und kann in gleicher Weise wie möglicherweise überständige dünne Kupferreste aufgrund von Inhomogenitäten in der Schichtdicke des Kupfers durch anschließendes kurzes Sputterätzen oder durch eine Tantal-Politur entfernt werden.

Von besonderem Vorteil des lösungsgemäßen Verfahrens ist die Herstellbarkeit einer vollkommenen planaren bzw. ebenen Substratoberfläche im Sinne einer globalen Planarisierung ohne jegliche Oberflächeneindellungen bzw. Einsenkungen (dishing) und dies ohne die Verwendung von Schleif- bzw. Poliermitteln, wodurch auch keinerlei zusätzliche Partikelreste auf der Substratoberfläche verbleiben können. Ebenso kann die durch einen konventionellen Poliervorgang hervorgerufene mechanische Scherbelastbarkeit der Werkstückoberfläche vollständig vermieden werden, die insbesondere höchst unzuträglich für poröse dielektrische Schichten sein kann (low-k dielectrics).

Sollten aufgrund eines langen Einsatzes des Ionen leitenden Werkzeuges werkzeugfremde Metallansammlungen innerhalb des Werkzeuges auftreten, so ist es möglich, durch Auflegen des Werkzeuges auf einer jeweils metallisierten Substratoberfläche und Umkehren der Polarität der elektrischen Spannung das Werkzeug wieder in den ursprünglichen Zustand zurückzuversetzen, indem werkzeugfremde Metallanteile im Wege der Ionenleitung vom Werkzeug abgegeben werden. In diesem Zusammenhang kann von einem Konditionieren der Werkzeugoberfläche gesprochen werden.

Da zu dem nicht ausgeschlossen werden kann, dass sich das Ionen leitende Material des Werkzeuges dennoch im Laufe der Zeit oberflächlich chemisch verändert, sobald beispielsweise das Werkzeug mit einer nicht aus Kupfer bestehenden Anode in Kontakt kommt, erscheint es besonders zweckmäßig, einen Ionenleiter auszuwählen, der nach Gebrauch kurzzeitig aufgeschmolzen werden kann, wie dies beispielsweise bei Kupfer-Rubidium-Chlorid der Fall ist. Auf diese Weise kann jederzeit eine chemisch gleichartige Oberfläche des Ionen leitenden Werkzeuges sichergestellt und zudem Oberflächendefekte, wie beispielsweise Kratzer, ausgeheilt werden.

Eine weitere Anwendungsmöglichkeit des lösungsgemäßen Verfahrens sieht den Einsatz von Pyrexglas als Werkzeugmaterial vor, zumal Pyrexglas bei Temperaturen von 300 bis 400°C ein Ionenleiter für Alkaliionen darstellt. Eine weitere interessante Eigenschaft von Pyrexglas besteht darin, dass es einerseits mit Silizium im Wege des anodischen Bondens verbunden werden kann, da eine elektrochemische Reaktion im Wege einer anodischen Oxidation in Kontakt mit Silizium stattfindet. Andererseits vermag Pyrexglas Ionen im Wege der Diffusion aufzunehmen, wie beispielsweise Silberionen, wodurch die elektrische Leitfähigkeit von Pyrexglas gezielt eingestellt werden kann. Auf der Grundlage dieser Eigenschaften von Pyrexglas kann das lösungsgemäße Verfahren zur Herstellung optisch wirksamer Strukturen im Mikro- und Nanobereich eingesetzt werden. Wird beispielsweise ein aus Pyrexglas bestehender Wafer mit einer Silberschicht bedampft, der nachfolgend als Substrat dient, auf dessen Silberschicht im weiteren ein als Werkzeug dienender zweiter strukturierter Pyrexglaswafer aufgesetzt wird, so kann durch Anlegen einer elektrischen Spannung zwischen dem Substrat und dem strukturierten Werkzeug die auf dem Substrat aufliegende Silberschicht jeweils in den Kontaktbereichen zu dem aus Pyrexglas bestehenden Werkzeug abgetragen, bzw. vollständig entfernt werden. In einem konkret durchgeführten diesbezüglichen Experiment wurden folgende Prozessparamter gewählt: T= 400°C, elektr. Spannung 100 V, Stromfluß 2 mA/cm², Prozesszeit ca. 200 sec. bei einer Ag-Schichtdicke von ca. 200 nm.
Je nach Strukturierung des aus Pyrexglas bestehenden Werkzeuges ist es möglich, auf Waferebene Mikro- und Nanostrukturen herzustellen und entsprechend zu replizieren. Damit eröffnet man sich beispielsweise die Möglichkeit optisch metallische Gitterstrukturen mit Linienbreiten und -abständen von bis hinab zu 20 nm zu replizieren. Derartige Gitterstrukturen können nicht nur als Transmissionsgitter, sondern sogar auch als optische Polarisatoren eingesetzt werden.

Die Replikation dreidimensionaler Silberfilme auf derartigen Pyrexglassubstraten kann auch dazu eingesetzt werden, um sogenannte Gradientenindex-Linsen herzustellen. Hierzu gilt es zwischen dem mit einer Silberschicht bedampften Pyrexglassubstrat und dem entsprechend strukturierten Pyrexglaswerkzeug eine umgekehrt zum vorstehenden Anwendungsfall gepolte elektrische Spannung anzulegen, so dass das Silber in das Glassubstrat hinein diffundieren kann und somit komplexe Diffusionsprofile innerhalb des Pyrexglassubstrates gebildet werden, die letztlich als Gradientenindex-Linsen eingesetzt werden können.

Die vorstehend beschriebenen Verfahrensvarianten beschreiben Materialabtragssowie auch Materialabscheideprozesse, bei denen weder Fremdstoffe gebildet werden, noch entsprechende Hilfsstoffe für eine erfolgreiche Prozessdurchführung bereitzustellen sind.

Werden anstelle der vorstehend beschriebenen kationischen Ionenleiter so genannte anionischen Ionenleiter als Werkzeugmaterialien eingesetzt, wie beispielsweise CaF₂, LaF₃ oder auch ZrO₂, eröffnet sich die Möglichkeit bestimmte Substratmaterialien an ihrer Oberfläche reaktiv zu ätzen und dadurch die Substratoberfläche effektiv lokal abzuformen. Gleichsam den vorstehend beschriebenen Anwendungsbeispielen wird die strukturierte Werkzeugoberfläche des nun aus anionischen lonenleitem bestehenden Werkzeuges auf der Substratoberfläche aufgesetzt, die vorzugsweise die Oberfläche eines Siliziumwafers darstellt. Bei Anlegen eines elektrischen Potenzials zwischen dem anionischen Ionenleiter des Werkzeuges und dem Siliziumwafer wandern bei Verwendung eines Fluor enthaltenen Ionenleiters die F⁻-Ionen aus dem Ionen leitenden Werkzeug an die Silizium-Wafer-Oberfläche, die mit dem Ionenleiter in Kontakt stehen und werden dort als Fluor-Atome bzw. Fluor-Moleküle lokal freigesetzt. Diese, sehr reaktiven Produkte reagieren unmittelbar mit dem Silizium zu SiF₄, das gasförmig ist und aus der Grenzfläche zu diffundieren vermag. Diese Situation ist in Figur 3 dargestellt, bei der die strukturierte, Fluor enthaltene Oberfläche des Werkzeuges 1 auf dem Silizium-Wafer S aufsitzt, wobei das Werkzeug 1 rückseitig einen Elektrolyt 5 aufweist, der wiederum mit einer Kathode K verbunden ist. Durch die zwischen dem Werkzeug 1 und dem Siliziumsubstrat S anliegende Potenzialdifferenz wandern Fluorionen an die dem Siliziumsubstrat S zugewandte Oberfläche des Werkzeuges 1, an der die Fluorionen als reaktives Gas F₂ freigesetzt werden und in Gegenwart des oberflächigen Siliziums zu SiF₄ reagieren.

Die Ionenleitfähigkeit des Ionen leitenden Werkzeugmaterials sowie die elektrische Leitfähigkeit des Silizium-Wafers S können überdies erhöht werden, sofern das Temperaturniveau auf Temperaturen zwischen 200 und 300°C erhöht wird. Auf diese Weise kann der reaktive Ätzvorgang an der Siliziumoberfläche sehr deutlich verbessert werden.

Zur Unterstützung des Abtransportes der sich zwischen dem Werkzeug 1 und der Siliziumoberfläche 2 ausbildenden, gasförmigen Reaktionsprodukte bietet es sich ferner an, das Werkzeug 1 zeitweise, vorzugsweise periodisch geringfügig von der Substratoberfläche abzuheben und wieder aufzusetzen. Auf diese Weise können die gasförmigen Reaktionsprodukte seitlich austreten. Dies könnte beispielsweise auch durch zusätzliches Einwirken von Ultra- oder Megaschall auf das Werkzeug bewerkstelligt werden.

Um sicherzustellen, dass eine Verarmung des Ionen leitenden Werkzeuges 1 an Fluorid-Ionen vermieden wird, gilt es kathodenseitig vorzugsweise eine Fluoridhaltige Salzschmelze als Reservoir an Fluor vorzusehen, die gemäß Ausführungsbeispiel in Figur 3 in Form eines Elektrolyts 5 bereitgestellt wird. Hiermit eröffnet sich grundsätzlich die Möglichkeit, refraktive oder auch diffraktive Linsen aus Silizium herzustellen bzw. diese zu replizieren. Unter Verwendung eines Sauerstoff leitenden Materials als Werkzeugmaterial, wie beispielsweise Zirkonium-Oxyd (ZrO₂) können, ganz analog zur Strukturierung von Silizium, auch Materialien wie Graphit oder Diamant dreidimensional strukturiert bzw. repliziert werden.

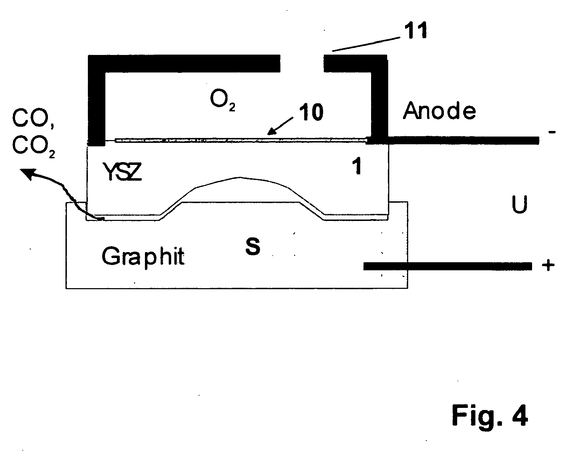

Besonders eignet sich als Werkzeugmaterial eine Yttrium stabilisiertes Zirkonoxidkeramik (YSZ). Der einfachste Aufbau ist in Figur 4 gezeigt, in der ein geeignet ausgeformtes Werkzeug 1 aus YSZ auf die Substratoberfläche 2 aus Graphit aufgesetzt ist. Die Ionenleitfähige Keramik wird rückseitig mit einer dünnen elektrisch leitfähigen Schicht 10, in diesem Fall aus Platin, beschichte, die dennoch hinreichend durchlässig für Sauerstoff bleibt.

Nach Aufsetzten des Werkzeuges 1 auf dem Graphit wird zwischen dem Graphit und der Rückseite des Werkzeuges eine Spannung U angelegt. Um eine ausreichende Ionische Leitfähigkeit der Keramik zu erreichen ist es notwenig die gesamte Anordnung auf eine Temperatur von ca. 400 °C in einer Sauerstoffhaltigen Atmosphäre aufzuheizen.

Unter diesen Bedingungen ist das Graphit gegenüber Sauerstoff einerseits noch stabil, anderseits aber besitzt die YSZ Keramik des Werkzeuges 1 eine ausreichende Leitfähigkeit und das Graphit ist hinreichen reaktiv um einen Ätzprozess in Gang zu bringen. Die Sauerstoffatmosphäre O₂ sorgt dabei für den eigentlichen Nachschub an Sauerstoff und verhindert die Ausbildung von Verarmungszonen im Ionenleiter. Unter diesen Bedingungen ist es bei einer Spannung um 80V und einer Stromdichte um 2 mA/cm² möglich, eine Ätzrate um 12 - 30 nm /min zu erreichen.
Eine deutlich größere Ätzrate ist allerdings erreichbar. wenn eine höhere Prozesstemperatur angewendet wird. Bei Temperaturen oberhalb von 500°C ist es allerdings unbedingt erforderlich das Graphit vor dem Sauerstoff zu schützten bzw. zu isolieren.
In diesem Fall wird das YSZ Werkzeug 1 rückseitig mit einer keramischen Zuleitung 11 verbunden, deren Innenvolumen mit einer Sauerstoffhaltigen Atmosphäre beaufschlagt wird. Der Raum außerhalb dieses Rohrs wird hingegen mit einem Schutzgas, Stickstoff oder Argon, gespült. Damit wird eine unerwünschte Reaktion des Graphits mit Sauerstoffresten weitgehend vermieden.

Um den lateralen Abtransport der Reaktionsprodukte, CO oder CO₂, insbesondere bei großflächigen Objekten zu erleichtern, kann unterstützend eine vertikale Vibrationsbewegung wie etwa Ultra- oder Megaschall eingeleitet werden.

Besonders interessant erscheint dieses Verfahren im Hinblick auf die Herstellung oder Replikation von Presswerkzeugen aus Glaskohlenstoff. Diese Werkzeuge eignen sich insbesondere als Formeneinsätze in Blankpressverfahren von Linsen für sehr hochschmelzende Werkstoffe wie Kieselglas.

### Bezugszeichenliste

- 1: Werkzeug
- 2: Substratoberfläche
- 3: konkav-förmige Ausnehmung
- 4: Umfangsrand
- 5: Elektrolyt
- 6: Dielektrikum
- 7: Tantal-Schicht
- 8: Kupferschicht
- S: Substrat
- A: Anode
- K: Kathode
- 10: Platinschicht
- 11: Keramische Zuleitung

## Patentansprüche

1. Verfahren zur Oberflächenbehandlung einer elektrisch leitenden, metallischen Substratoberfläche (2), bei dem ein festes Ionen leitendes Material aufweisendes Werkzeug (1) wenigstens bereichsweise kraftbeaufschlagt auf die Substratoberfläche (2) gepresst wird, das Metallionen der Substratoberfläche (2) zu leiten in der Lage ist und an das ein elektrisches Potenzial angelegt wird, so dass zwischen der Substratoberfläche (2) und dem Werkzeug (1) ein elektrisches Potenzialgefälle derart anliegt, dass die Metallionen durch das Werkzeug (1) von der Substratoberfläche (2) abgezogen oder auf die Substratoberfläche (2) äbgeschieden werden.

2. Verfahren nach Anspruch 1,
**dadurch gekennzeichnet, dass** das Werkzeug eine der Substratoberfläche (2) zugewandte und abgewandte Seite aufweist, und
dass das elektrische Potenzial zwischen der Substratoberfläche (2) und der der Substratoberfläche abgewandte Seite des Werkzeuges (1) angelegt wird.

3. Verfahren nach Anspruch 1 oder 2,
**dadurch gekennzeichnet, dass** als Reservoir an der der Substratoberfläche abgewandten Seite des Werkzeuges (1) ein die Metallionen aufnehmender oder abgebender flüssiger Elektrolyt (5) vorgesehen wird.

4. Verfahren nach einem der Ansprüche 1 bis 3,
**dadurch gekennzeichnet, dass** bei Verwendung eines Werkzeuges (1) mit einer glatten planen Werkzeugoberfläche, die auf die Substratoberfläche (2) aufgesetzt wird, und durch Anlegen eines elektrischen Potenzials derart, dass Metallionen aus der Substratoberfläche (2) austreten und vom Werkzeug (1) aufgenommen werden, ein Materialabtragsvorgang initiiert wird, durch den die Substratoberfläche (2) planarisiert wird.

5. Verfahren nach einem der Ansprüche 1 bis 3,
**dadurch gekennzeichnet, dass** bei Verwendung eines Werkzeuges (1) mit einer strukturierten Werkzeugoberfläche, die auf die Substratoberfläche (2) aufgesetzt wird,
und durch Anlegen eines elektrischen Potenzials derart, dass Metallionen aus der Substratoberfläche (2) in Bereichen, in denen das Werkzeug (1) mit der Substratoberfläche (2) in Kontakt steht, vom Werkzeug aufgenommen werden, ein lokal begrenzter Materialabtragsvorgang realisiert wird, durch den die Substratoberfläche (2) gleichsam eines lokalen Ätzvorganges strukturiert wird.

6. Verfahren nach einem der Ansprüche 1 bis 5,
**dadurch gekennzeichnet, dass** das Ionen leitende Material des Werkzeuges (1) derart ausgewählt wird, dass die von der Substratoberfläche (2) aufgenommenen Ionen ausschließlich durch das Werkzeug (1) transportiert werden ohne dessen chemische Zusammensetzung zu verändern.

7. Verfahren nach einem der Ansprüche 1 bis 6,
**dadurch gekennzeichnet, dass** als Substrat ein Substrat mit einer KupferSubstratoberfläche und ein aus Kupfer-Rubidium Chlorid aufweisendes Werkzeug (1) verwendet wird.

8. Verfahren nach einem der Ansprüche 1 bis 6,
**dadurch gekennzeichnet, dass** das Substrat eine Substratoberfläche vorsieht, die aus Silber oder aus einer Silber/Kupferlegierung besteht.

9. Verfahren nach einem der Ansprüche 1 bis 8,
**dadurch gekennzeichnet, dass** durch Vorsehen einer glatten sowie plan oder gekrümmt ausgebildeten Werkzeugoberfläche ein Herstellen spiegelnder Oberflächen, insbesondere eine Replikation von Laserspiegeln ermöglicht wird.

10. Verfahren nach einem der Ansprüche 1 bis 9,
**dadurch gekennzeichnet, dass** wenigstens das Werkzeug über Raumtemperatur erwärmt wird, vorzugsweise auf etwa 80°C.

11. Verfahren nach einem der Ansprüche 1 bis 6,
**dadurch gekennzeichnet, dass** ein Pyrexglas aufweisendes Werkzeug verwendet wird, das bei Temperaturen zwischen 300 und 400 °C auf eine Alkaliionen enthaltende Subratoberfläche aufgesetzt wird.

12. Verfahren nach Anspruch 11,
**dadurch gekennzeichnet, dass** das Substrat eine Oberfläche aufweist, auf der eine Silber enthaltende Schicht aufgebracht wird, die die Substratoberfläche (2) bildet,
dass auf die Substratoberfläche ein strukturiertes Werkzeug (1) aus Pyrexglas aufgesetzt wird, und dass ein elektrisches Potenzial zwischen dem Werkzeug (1) und der Substratoberfläche (2) derart angelegt wird, dass die Silberschicht in den Bereichen, in denen das Werkzeug (1) auf der Substratoberfläche aufliegt, zumindest teilweise abgetragen wird.

13. Verfahren nach Anspruch 12,
**dadurch gekennzeichnet, dass** die Strukturierung des Werkzeuges derart vorgenommen wird, dass durch Aufsetzen des Werkzeuges auf die Substratoberfläche Mikrostrukturen auf der mit der Silberschicht versehenen Substratoberfläche entstehen mit Größendimensionen von bis hinab zu 20 nm.

14. Verfahren nach Anspruch 13,
**dadurch gekennzeichnet, dass** die Strukturierung des Werkzeuges zur Herstellung optischer Gitter oder optischer Polarisatoren verwendet werden.

15. Verfahren nach einem der Ansprüche 1 bis 6,
**dadurch gekennzeichnet, dass** ein Pyrexglas aufweisendes Werkzeug verwendet wird, das bei Temperaturen zwischen 300 und 400 °C auf eine glasartige und ionenaustauschende Subratoberfläche aufgesetzt wird,
dass das Werkzeug mit seiner der Substratoberfläche abgewandten Seite mit einem Alkaliionen enthaltenden Reservoir verbunden wird, und
dass zwischen der Substratoberfläche und dem Reservoir ein elektrisches Potenzial angelegt wird, so dass die Alkaliionen durch das Werkzeug hindurch in die Substratoberfläche eindiffundieren.

16. Verfahren nach Anspruch 15,
**dadurch gekennzeichnet, dass** das als Alkaliionen Silberionen verwendet werden.

17. Verfahren nach Anspruch 15 oder 16,
**dadurch gekennzeichnet, dass** das Eindiffundieren der Alkaliionen innerhalb der Substratoberfläche derart erfolgt, dass sich wenigstens ein Diffusionsstoffprofil ausbildet, durch das eine optische Gradientenindex-Linse erzeugt wird.

## Claims

1. A method for treating the surface of an electrically conductive metal substrate surface (2), in which a tool (1) comprising a solid ion-conducting material is pressed under force onto the substrate surface (1), at least in some regions, said material being able to conduct metal ions of the substrate surface (2) and an electric potential being applied to said material so that an electric potential drop is applied between the substrate surface (2) and the tool (1) in such a way that the metal ions are drawn from the substrate surface (2) by the tool (1) or are deposited on the substrate surface (2).

2. The method according to claim 1, **characterised in that** the tool has a side facing the substrate surface (2) and a side facing away from the substrate surface (2), and **in that** the electric potential is applied between the substrate surface (2) and the side of the tool (1) facing away from the substrate surface (2).

3. The method according to claim 1 or 2, **characterised in that** a liquid electrolyte (5) which accepts or releases the metal ions is provided as a reservoir on the side of the tool (1) facing away from the substrate surface.

4. The method according to one of claims 1 to 3, **characterised in that**, when using a tool (1) with a smooth planar tool surface placed on the substrate surface (2), and by applying an electric potential in such a way that metal ions emerge from the substrate surface (2) and are accepted by the tool (1), a material removal process is initiated, as a result of which the substrate surface (2) is planarised.

5. The method according to one of claims 1 to 3, **characterised in that**, when using a tool (1) having a structured tool surface placed on the substrate surface (2), and by applying an electric potential in such a way that metal ions from the substrate surface (2) are accepted by the tool in regions in which the tool (1) is in contact with the substrate surface (2), a locally defined material removal process is implemented, as a result of which the substrate surface (2) is structured in a quasi local etching process.

6. The method according to one of claims 1 to 5, **characterised in that** the ion-conducting material of the tool (1) is selected in such a way that the ions accepted by the substrate surface (2) are transported exclusively by the tool (1), without the chemical composition thereof being changed.

7. The method according to one of claims 1 to 6, **characterised in that** a substrate with a copper substrate surface is used as a substrate and a tool (1) comprising copper rubidium chloride is used.

8. The method according to one of claims 1 to 6, **characterised in that** the substrate provides a substrate surface which consists of silver or of a silver/copper alloy.

9. The method according to one of claims 1 to 8, **characterised in that**, by providing a smooth and planar or curved tool surface, it is possible to produce reflective surfaces, in particular a replication of laser mirrors.

10. The method according to one of claims 1 to 9, **characterised in that** at least the tool is heated above room temperature, preferably to approximately 80 °C.

11. The method according to one of claims 1 to 6, **characterised in that** a tool comprising Pyrex glass is used and is placed on a substrate surface containing alkali ions at temperatures between 300 and 400 °C.

12. The method according to claim 11, **characterised in that** the substrate comprises a surface on which a layer containing silver is applied and forms the surface substrate (2), **in that** a structured tool (1) made of Pyrex glass is placed on the substrate surface, and **in that** an electric potential is applied between the tool (1) and the substrate surface (2) in such a way that the silver layer is removed, at least in part, in the regions in which the tool (1) rests on the substrate surface.

13. The method according to claim 12, **characterised in that** the tool is structured in such a way that, by placing the tool on the substrate surface, microstructures are formed on the substrate surface provided with the silver layer and are as small as 20 nm.

14. The method according to claim 13, **characterised in that** the tool is structured so as to produce optical grids or optical polarisers.

15. The method according to one of claims 1 to 6, **characterised in that** a tool comprising Pyrex glass is used and is placed on a glassy and ion-exchanging substrate surface at temperatures between 300 and 400 °C, **in that** the tool is connected to a reservoir containing alkali ions via its side facing away from the substrate surface, and **in that** an electric potential is applied between the substrate surface and the reservoir so that the alkali ions diffuse through the tool and into the substrate surface.

16. The method according to claim 15, **characterised in that** silver ions are used as alkali ions.

17. The method according to claim 15 or 16, **characterised in that** the alkali ions diffuse within the substrate surface in such a way that at least one diffusion material profile is formed, by which an optical gradient index lens is produced.

## Revendications

1. Procédé de traitement de surface d'une surface de substrat métallique (2), électriquement conductrice, dans lequel un outil (1) stationnaire présentant un matériau conducteur d'ions est au moins localement plaqué contre la surface de substrat (2) en étant sollicité par une force, ledit outil étant en mesure de conduire des ions métalliques issus de la surface de substrat (2) et auquel on applique un potentiel électrique de sorte qu'entre la surface de substrat (2) et l'outil (1) un gradient de potentiel électrique est appliqué de telle sorte que l'outil (1) retire les ions métalliques de la surface de substrat (2) ou les dépose sur la surface de substrat (2).

2. Procédé selon la revendication 1, **caractérisé en ce que** l'outil présente un côté tourné vers et un côté détourné de la surface de substrat (2), et **en ce que** le potentiel électrique est appliqué entre la surface de substrat (2) et le côté de l'outil (1) détourné de la surface de substrat.

3. Procédé selon la revendication 1 ou 2, **caractérisé en ce que** sur le côté de l'outil (1) détourné de la surface de substrat, un électrolyte liquide (5) recevant ou libérant des ions métalliques est prévu comme réservoir.

4. Procédé selon l'une quelconque des revendications 1 à 3, **caractérisé en ce qu'**en utilisant un outil (1) à surface d'outil plane et lisse, qui est posé sur la surface de substrat (2), et en appliquant un potentiel électrique de telle sorte que des ions métalliques se dégagent de la surface de substrat (2) et sont absorbés par l'outil (1), un processus d'enlèvement de matière est déclenché qui permet de planariser la surface de substrat (2).

5. Procédé selon l'une quelconque des revendications 1 à 3, **caractérisé en ce qu'**en utilisant un outil (1) à surface d'outil texturée et qui est posé sur la surface de substrat (2), et en appliquant un potentiel électrique de telle sorte que des ions métalliques issus de la surface de substrat (2) sont absorbés par l'outil dans des zones où l'outil (1) est en contact avec la surface de substrat (2), un processus d'enlèvement de matière localement limité est réalisé qui permet de texturer la surface de substrat (2) à la manière d'un processus de gravure locale.

6. Procédé selon l'une quelconque des revendications 1 à 5, **caractérisé en ce que** le matériau conducteur d'ions de l'outil (1) est choisi de telle sorte que les ions absorbés par la surface de substrat (2) sont transportés exclusivement par l'outil (1) sans pour autant altérer la composition chimique de celui-ci.

7. Procédé selon l'une quelconque des revendications 1 à 6, **caractérisé en ce que** pour le substrat, on utilise un substrat à surface de substrat en cuivre et un outil (1) comportant du chlorure de cuivre/rubidium.

8. Procédé selon l'une quelconque des revendications 1 à 6, **caractérisé en ce que** le substrat prévoit une surface de substrat qui se compose d'argent ou d'un alliage d'argent/cuivre.

9. Procédé selon l'une quelconque des revendications 1 à 8, **caractérisé en ce que** le fait de prévoir une surface d'outil lisse et réalisée de manière plane ou bien courbe permet de fabriquer des surfaces réfléchissantes, en particulier une réplication de miroirs laser.

10. Procédé selon l'une quelconque des revendications 1 à 9, **caractérisé en ce qu'**au moins l'outil est chauffé au-dessus de la température ambiante, de préférence jusqu'à environ 80 °C.

11. Procédé selon l'une quelconque des revendications 1 à 6, **caractérisé en ce qu'**un outil comportant du verre Pyrex est utilisé, qui est posé sur une surface de substrat contenant des ions alcalins, à des températures entre 300 et 400 °C.

12. Procédé selon la revendication 11, **caractérisé en ce que** le substrat présente une surface sur laquelle une couche contenant de l'argent est appliquée qui constitue la surface de substrat (2), **en ce qu'**un outil texturé (1) en verre Pyrex est posé sur la surface de substrat, et **en ce qu'**un potentiel électrique est appliqué entre l'outil (1) et la surface de substrat (2) de telle sorte que la couche d'argent est enlevée au moins en partie dans des zones où l'outil (1) repose sur la surface de substrat.

13. Procédé selon la revendication 12, **caractérisé en ce que** la texturisation de l'outil est réalisée de telle sorte que le fait de poser l'outil sur la surface de substrat crée des microstructures sur la surface de substrat munie de la couche d'argent, avec des dimensions allant jusqu'à 20 nm.

14. Procédé selon la revendication 13, **caractérisé en ce que** la texturisation de l'outil est utilisée pour fabriquer des réseaux optiques ou des polariseurs optiques.

15. Procédé selon l'une quelconque des revendications 1 à 6, **caractérisé en ce qu'**un outil comportant du verre Pyrex est utilisé, qui est posé sur une surface de substrat de type verre, échangeuse d'ions, à des températures entre 300 et 400 °C, **en ce que** l'outil est relié à un réservoir contenant des ions alcalins par son côté détourné de la surface de substrat, et **en ce qu'**entre la surface de substrat et le réservoir, un potentiel électrique est appliqué de sorte que les ions alcalins se diffusent à l'intérieur de la surface de substrat en passant à travers l'outil.

16. Procédé selon la revendication 15, **caractérisé en ce que** des ions d'argent sont utilisés comme ions alcalins.

17. Procédé selon la revendication 15 ou 16, **caractérisé en ce que** la diffusion des ions alcalins à l'intérieur de la surface de substrat est effectuée de façon à réaliser au moins un profil de substance de diffusion permettant de générer une lentille optique à gradient d'indice.
